# EUROPEAN PATENT SPECIFICATION

(11) **EP 2 319 047 B1**
(45) Date of publication and mention of the grant of the patent: **24.09.2014**
(21) Application number: 09786168.6
(22) Date of filing: 21.08.2009
(51) Int. Cl.: G11C 16/20, G06F 13/38

(54) **MULTIPLE PERFORMANCE MODE MEMORY SYSTEM**
SPEICHERSYSTEM MIT MEHREREN LEISTUNGSBETRIEBSARTEN
SYSTÈME DE MÉMOIRE DOTÉ DE PLUSIEURS MODES DE PERFORMANCE

(30) Priority: 26.08.2008 US 198635
(43) Date of publication of application: 11.05.2011
(73) Proprietor: SanDisk IL Ltd., 44425 Kfar Saba (IL)
(72) Inventor: LASSER, Menahem, Kohav-Yair 44864 (IL)
(74) Representative: Hitchcock, Esmond Antony
(86) International application number: PCT/IB2009/006615
(87) International publication number: WO 2010/023529

(56) References cited:
- WO-A2-2006/131915

## Description

This application relates generally to memory devices. More specifically, this application relates to setting a performance mode of reprogrammable non-volatile semiconductor flash memory.

Non-volatile memory systems, such as flash memory, have been widely adopted for use in consumer products. Flash memory may be found in different forms, for example in the form of a portable memory card that can be carried between host devices or as a solid state disk (SSD) embedded in a host device. When writing data to a conventional flash memory system, a host typically writes data to, and reads data from, addresses within a logical address space of then memory system. The memory system then commonly maps data between the logical address space and the physical blocks or metablocks of the memory, where data is stored in fixed logical groups corresponding to ranges in the logical address space. Generally, each fixed logical group is stored in a separate physical block of the memory system. The memory system keeps track of how the logical address space is mapped into the physical memory but the host is unaware of this. The host keeps track of the addresses of its data files within the logical address space but the memory system generally operates without knowledge of this mapping.

A drawback of memory systems that operate in this manner is fragmentation. For example, data written to a solid state disk (SSD) drive in a personal computer (PC) operating according to the NTFS file system is often characterized by a pattern of short runs of contiguous addresses at widely distributed locations within the logical address space of the drive. Even if the file system used by a host allocates sequential addresses for new data for successive files, the arbitrary pattern of deleted or updated files causes fragmentation of the available free memory space such that it cannot be allocated for new file data in blocked units.

The deletion or updating of files by the host may cause some data in a physical block in the memory system to become obsolete, resulting in partially obsolete blocks that contain both valid and obsolete data. These physical blocks partially filled with obsolete data represent memory capacity that cannot be used until the valid data in the block is moved to another block so that the original block may be erased and made available for receiving more data. The process of moving the valid data into another block and preparing the original block for receiving new data is sometimes referred to as a housekeeping function or garbage collection. As a memory system accumulates obsolete blocks, e.g., blocks partially filled with obsolete data, those blocks are unavailable for receiving new data. When enough of the obsolete blocks accumulate, the memory device may be unable to service requests from the host and housekeeping functions may be necessary.

Two numbers generally specify the write performance of a memory device. The first number is the burst write speed. Burst write speed is the rate at which the memory device can absorb an input stream of data when there is enough room in the memory device. The second number is the sustained write speed. Sustained write speed is the rate at which the memory device can absorb streams of input data that are much larger than the available write blocks.

The write performance of a memory device may be affected by how much data has been stored in the memory device. If the storage capacity is close to full, garbage collection may be necessary. The valid data in blocks being garbage collected must be copied to new locations in order to free those blocks to receive new data. The write performance of the memory device declines as garbage collections occur because new data cannot be written until free blocks are made available by the garbage collection. The working area capacity used for garbage collection and other housekeeping operations, relative to the storage capacity, can therefore affect the write performance of the memory device. For a given amount of data stored, a typical memory device has a single write performance level based on its storage capacity and its working area capacity.

WO2006/131915 discloses a memory device and method of controlling a memory device according to the preambles of the independent claims.

In order to address the problems noted above, a method and system for controlling the performance mode of a memory device is disclosed.

According to a first aspect of the invention there is provided a method for controlling a memory comprising receiving an input at the memory. If the input comprises a first input the memory is configured to a first operation mode. The first operation mode provides a first write performance level and a first storage capacity. If the input comprises a second input the memory is configured to a second operation mode. The second operation mode provides a second write performance level and a second storage capacity. The first operation mode and the second operation mode store a same number of bits per cell in the memory and the first storage capacity is larger than the second storage capacity. The first and second working area capacities comprise at least one of a buffer or a garbage collection space. A ratio of first working area capacity reserved for internal use within the memory to first storage capacity In the first operation mode is less than a ratio of second working area capacity reserved for Internal use within the memory to second storage capacity in the second write performance mode such that the first write performance level is lower than the second write performance level. The write performance is a write speed.

The method may further include prohibiting configuration of the memory to the second operation mode if the memory has already been formatted. Receiving the input may include receiving the input prior to or when the memory is being formatted. The first and second write performance levels may include at least one of a burst write speed or a sustained write speed. Configuring the memory to the first operation mode may include allocating a first working area capacity for internal use within the memory, where the first working area capacity is less than or equal to the first storage capacity subtracted from a total capacity. Configuring the memory to the second operation mode may include allocating a second working area capacity for internal use within the memory, where the second working area capacity is less than or equal to the second storage capacity subtracted from the total capacity. The first and second working area capacities may include at least one of a buffer or a garbage collection space. The input may include a software command or hardware setting specifying at least one of a write performance level or a storage capacity. The software command may be received from a host. The hardware setting may include at least one of a switch or a jumper. The received input may affect only a portion of a storage capacity of the memory,

In another aspect of the invention there is provided a memory device comprising a memory and a controller for controlling the memory and configured to receive an input at the memory. If the input comprises a first input, the memory is configured to a first operation mode. The first operation mode provides a first write performance level and a first storage capacity. If the input comprises a second input the memory is configured to a second operation mode. The second operation mode provides a second write performance level and a second storage capacity. The first storage capacity is larger than the second storage capacity and the first operation. mode and the second operation mode store a same number of bits per cell in the memory. The first and second working area capacities comprise at least one of a buffer or a garbage collection space. A ratio of first working area capacity reserved for internal use within the memory to first storage capacity in the first operation mode is less than a ratio of second working area capacity reserved for internal use within the memory to second storage capacity in the second operating mode such that the first write performance level is lower than the second write performance level. The write performance is a write speed.

The controller may be further configured to prohibit configuration of the memory to the second operation mode if the memory has already been formatted. Receiving the input may include receiving the input prior to or when the memory is being formatted The first and second write performance levels may Include at least one of a burst write speed or a sustained write speed. The controller may be further configured to allocate a first working area capacity for internal use within the memory, where the first working area capacity is less than or equal to the first storage capacity subtracted from a total capacity. The controller may also be configured to allocate a second working area capacity for internal use within the memory, where the second working area capacity is less than or equal to the second storage capacity subtracted from the total capacity. The first and second working area capacities may include at least one of a buffer or a garbage collection space. The input may include a software command specifying at least one of a write performance level or a storage capacity and the memory device may include an interface arranged to receive the software command. The memory device may alternately include a hardware interface for receiving the input to specify at least one of a write performance level or a storage capacity. The hardware interface may include at least one of a switch or a jumper. The received input may affect only a portion of a storage capacity of the memory.

A method is further disclosed for controlling a memory, including receiving an input at the memory. If the input comprises a first input, the method configures the memory to a first ratio, and if the input comprises a second input, the method configures the memory to a second ratio. The memory includes a total capacity. The first ratio includes a ratio of a first storage capacity to a first working area capacity that is less than or equal to the first storage capacity subtracted from the total capacity. The second ratio includes a ratio of a second storage capacity to a second working area capacity that is less than or equal to the second storage capacity subtracted from the total capacity. The first ratio is higher than the second ratio. The method may further include prohibiting configuration of the memory to the second ratio if the memory has already been formatted. Receiving the input may Include receiving the input prior to or when the memory is being formatted. The first and second working area capacities may include at least one of a buffer or a garbage collection space. The input may comprise at least one of a software command or a hardware setting specifying at least one of a write performance level or a storage capacity.
FIG. 1 is a block diagram of a host connected with a memory system having non-volatile memory.
FIG. 2 illustrates an example physical memory organization of the system of FIG. 1.
FIG. 3 shows an expanded view of a portion of the physical memory of FIG. 2.
FIG. 4 illustrates a typical pattern of allocated and free clusters by blocks in an exemplary data management scheme.
FIG. 5 is a state diagram of the allocation of blocks of clusters.
FIG. 6 illustrates an example pattern of allocated and free clusters in blocks and of data written to the memory system from a host.
FIG. 7 illustrates an example of a flush operation of a physical block.
FIG. 8 illustrates a second example of a flush operation of a physical block following the flush operation of FIG. 7.
FIG. 9 illustrates an example memory capacity organization.
FIG. 10 illustrates an example memory capacity organization for multiple partitions.
FIG. 11 is a flow diagram illustrating a method of setting a performance mode of a memory device according to an embodiment.

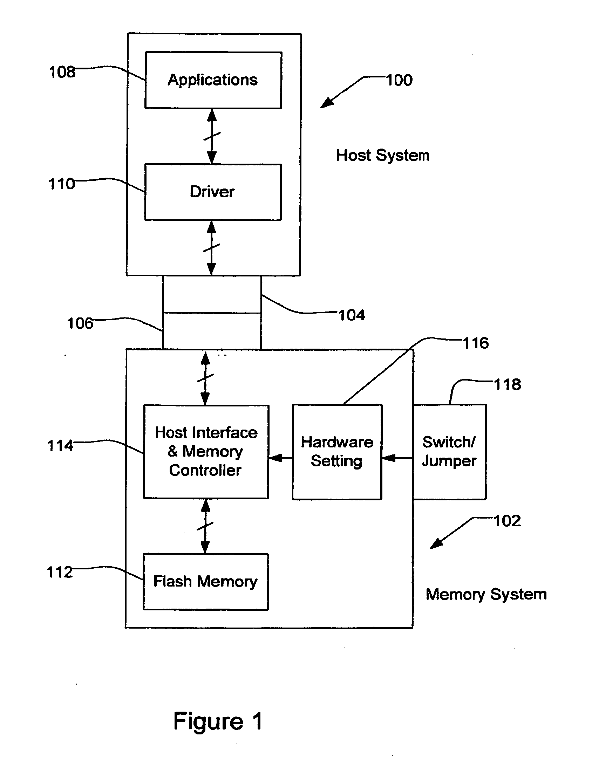

An exemplary flash memory system suitable for use in implementing aspects of the invention is shown in FIGS. 1-3. Other memory systems are also suitable for use in implementing the invention. A host system 100 of FIG. 1 stores data into and retrieves data from a flash memory 102. The flash memory may be embedded within the host, such as in the form of a solid state disk (SSD) drive installed in a personal computer. Alternatively, the memory 102 may be in the form of a card that is removably connected to the host through mating parts 104 and 106 of a mechanical and electrical connector as illustrated in FIG. 1. A flash memory configured for use as an internal or embedded SSD drive may look similar to the schematic of FIG. 1, with the primary difference being the location of the memory system 102 internal to the host. SSD drives may be in the form of discrete modules that are drop-in replacements for rotating magnetic disk drives.

One example of a commercially available SSD drive is a 32 gigabyte SSD produced by SanDisk Corporation. Examples of commercially available removable flash memory cards include the CompactFlash (CF), the MultiMediaCard (MMC), Secure Digital (SD), miniSD, Memory-Stick, SmartMedia, and microSD cards. Although each of these cards has a unique mechanical and/or electrical interface according to its standardized specifications, the flash memory system included in each is similar. These cards are all available from SanDisk Corporation, assignee of the present application. SanDisk also provides a line of flash drives under its Cruzer trademark, which are hand held memory systems in small packages that have a Universal Serial Bus (USB) plug for connecting with a host by plugging into the host's USB receptacle. Each of these memory cards and flash drives includes controllers that interface with the host and control operation of the flash memory within them.

Host systems that may use SSDs, memory cards and flash drives are many and varied. They include personal computers (PCs), such as desktop or laptop and other portable computers, cellular telephones, personal digital assistants (PDAs), digital still cameras, digital movie cameras and portable audio players. For portable memory card applications, a host may include a built-in receptacle for one or more types of memory cards or flash drives, or a host may require adapters into which a memory card is plugged. The memory system usually contains its own memory controller and drivers but there are also some memory-only systems that are instead controlled by software executed by the host to which the memory is connected. In some memory systems containing the controller, especially those embedded within a host, the memory, controller and drivers are often formed on a single integrated circuit chip.

The host system 100 of FIG. 1 may be viewed as having two major parts, insofar as the memory 102 is concerned, made up of a combination of circuitry and software. They are an applications portion 108 and a driver portion 110 that interfaces with the memory 102. In a PC, for example, the applications portion 108 can include a processor running word processing, graphics, control or other popular application software. In a camera, cellular telephone or other host system that is primarily dedicated to performing a single set of functions, the applications portion 108 includes the software that operates the camera to take and store pictures, the cellular telephone to make and receive calls, and the like.

The memory system 102 of FIG. 1 includes flash memory 112, and circuits 114 that both interface with the host to which the card is connected for passing data back and forth and control the memory 112. The controller 114 typically converts between logical addresses of data used by the host 100 and physical addresses of the memory 112 during data programming and reading. The memory system 102 may also include a switch or jumper 118 that configures a hardware setting 116 to adjust parameters of the memory system 102, such as a write performance level or a storage capacity of the memory system 102.

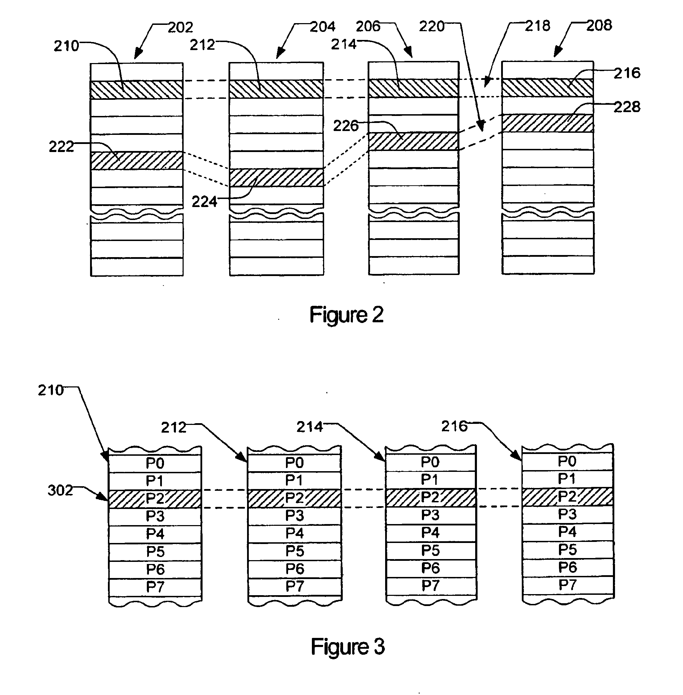

FIG. 2 conceptually illustrates an organization of the flash memory cell array 112 (FIG. 1) that is used as an example in further descriptions below. Four planes or sub-arrays 202, 204, 206, and 208 of memory cells may be on a single integrated memory cell chip, on two chips (two of the planes on each chip) or on four separate chips. The specific arrangement is not important to the discussion below. Of course, other numbers of planes, such as 1, 2, 8, 16 or more may exist in a system. The planes are individually divided into groups of memory cells that form the minimum unit of erase, hereinafter referred to as erase blocks. Erase blocks of memory cells are shown in FIG. 2 by rectangles, such as erase blocks 210, 212, 214, and 216, located in respective planes 202, 204, 206, and 208. There can be dozens or hundreds of erase blocks in each plane.

As mentioned above, the erase block of memory cells is the unit of erase, the smallest number of memory cells that are physically erasable together. For increased parallelism, however, the erase blocks are operated in larger metablock units. One erase block from each plane is logically linked together to form a metablock. The four erase blocks 210, 212, 214, and 216 are shown to form one metablock 218. All of the cells within a metablock are typically erased together. The erase blocks used to form a metablock need not be restricted to the same relative locations within their respective planes, as is shown in a second metablock 220 made up of erase blocks 222, 224, 226, and 228. Although it is usually preferable to extend the metablocks across all of the planes, for high system performance, the memory system can be operated with the ability to dynamically form metablocks of any or all of one, two or three erase blocks in different planes. This allows the size of the metablock to be more closely matched with the amount of data available for storage in one programming operation.

The individual erase blocks are in turn divided for operational purposes into pages of memory cells, as illustrated in FIG. 3. The memory cells of each of the blocks 210, 212, 214, and 216, for example, are each divided into eight pages PO-P7. Alternatively, there may be 16, 32 or more pages of memory cells within each block. The page is the unit of data programming and reading within an erase block, containing the minimum amount of data that are programmed or read at one time. However, in order to increase the memory system operational parallelism, such pages within two or more erase blocks may be logically linked into metapages. A metapage 302 is illustrated in FIG. 3, being formed of one physical page from each of the four erase blocks 210, 212, 214, and 216. The metapage 302, for example, includes the page P2 in each of the four blocks but the pages of a metapage need not necessarily have the same relative position within each of the blocks. A metapage is the maximum unit of programming.

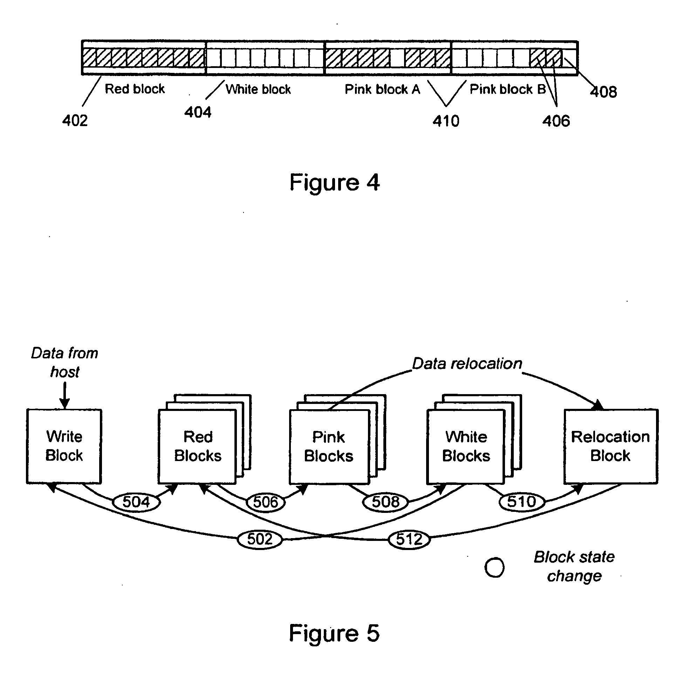

An overview of an exemplary data management scheme that may be used with the memory system 102 is illustrated in FIGS. 4-8. This data management scheme, also referred to as storage address remapping, operates to take logical block addresses (LBAs) associated with data sent by the host and remaps them to a second logical address space or directly to physical address space in an order the data is received from the host. Each LBA corresponds to a sector, which is the minimum, unit of logical address space addressable by a host. A host will typically assign data in clusters that are made up of one or more sectors. Also, in the following discussion, the term block is a flexible representation of storage space and may indicate an individual erase block or, as noted above, a logically interconnected set of erase blocks defined as a metablock. If the term block is used to indicate a metablock, then a corresponding logical block of LBAs should consist of a block of addresses of sufficient size to address the complete physical metablock.

FIG. 4 illustrates a typical pattern of allocated and free clusters by blocks in the memory system 102 and the flash memory 112. Data to be written from the host system 100 to the memory system 102 may be addressed by clusters of one or more sectors managed in blocks. A write operation may be handled by writing data into individual blocks, and completely filling that block with data in the order data is received, regardless of the LBA order of the data, before proceeding to the next available block. This allows data to be written in completed blocks by creating blocks with only unwritten capacity by means of flushing operations on partially obsolete blocks containing obsolete and valid data. In the following description, blocks completely filled with valid data are referred to as red blocks 402, blocks with only unwritten capacity are referred to as white blocks 404, and partially obsolete blocks with both valid (allocated) 406 and obsolete (deallocated) 408 data are referred to as pink blocks 410.

For example, a white block 404 may be allocated as the sole location for writing data, and the addresses of the white block 404 may be sequentially associated with data at the current position of its write pointer in the order it is provided by the host. When a block of storage addresses becomes fully allocated to valid data, it is known as a red block 402. When files are deleted or updated by the host, some addresses in a red block 402 may no longer be allocated to valid data, and the block becomes known as a pink block 410.

A white block 404 may be created from a pink block 410 by relocating valid data from the pink block 410 to a relocation block, a garbage collection operation known as flushing. The relocation block may be a newly allocated white block 404 if no unwritten capacity exists in a prior relocation block. As with the write operation from a host described above, the relocation of valid data in the flush operation may not be tied to keeping any particular block of addresses together. Thus, valid data being flushed from a pink block 410 to the current relocation block is copied in the order it appears in the pink block to sequential locations in the relocation block and the relocation block may contain other valid data relocated from other, unrelated pink blocks. Flush operations may be performed as background operations or foreground operations, to transform pink blocks 410 into white blocks 404. A background flush of pink blocks may operate when the host interface is idle, and may be disabled when the host interface becomes active. A foreground flush of pink blocks may operate when the host interface is active and interleave data writing operations with physical block flushing operations until a write command is completed.

A pink block 410 may be selected for a flush operation according to its characteristics. In one implementation, a pink block 410 with the least amount of valid data (i.e., the fewest shaded clusters in FIG. 4) would be selected because fewer addresses with valid data results in less data needing relocation when that particular pink block is flushed. In this implementation, the pink block 410 is not selected in response to specific write, read, and/or erase operations performed by the host. Thus, in the example of FIG. 4, pink block B would be selected in preference to pink block A because pink block B has fewer addresses with valid data. Selection of pink blocks as flush blocks in this manner allows performance of block flush operations with a minimum relocation of valid data because any pink block so selected will have accumulated a maximum amount of unallocated data due to deletion or updating of files by the host. Alternatively, the selected pink block for a flush operation may be based on other parameters, such as a calculated probability of further erasures or updates in a particular pink block.

In one implementation of the flushing algorithm, a pink block may be selected for a flush operation based on a block information table (BIT) maintained by the memory system 102. The BIT is created by the memory system 102 and stored in flash memory 112. The BIT contains lists of types of blocks (such as pink blocks, white blocks) and, for pink blocks, stores LBA run data associated with each pink block. The memory system 102 takes the LBA run information found in the BIT for a given pink block and looks up the amount of valid data associated with the LBA run in a storage address table (SAT). The SAT is another table maintained by the memory system, where the SAT tracks the relation of each host assigned LBA address to its storage address in the memory system.

FIG. 5 is a state diagram of the allocation of blocks according to an embodiment of a flush algorithm. As noted above, address space may be allocated in terms of blocks and a block is filled up before allocating another block of clusters. This may be accomplished by first allocating a white block 404 to be the current write block to which data from the host is written, where the data from the host is written to the write block in sequential order according to the time it is received (at step 502). When the last page in the current write block is filled, the current write block becomes a red block (at step 504) and a new write block is allocated from the pool of white blocks. It should be noted that the current write block may also make a direct transition to a pink block if some pages within the current write block have already become obsolete before the current write block is filled. This transition is not shown, for clarity; however it could be represented by an arrow from the write block to a pink block.

When one or more pages within a red block are made obsolete by deletion or updating of files, the red block becomes a pink block (at step 506). The memory system may detect the quantity of available memory, including the quantity of white blocks or memory blocks having at least a portion of unwritten capacity. When there is a need for more white blocks, a flush operation may move the valid data from a pink block to available memory so that the pink block becomes a white block (at step 508). In order to flush a pink block, the valid data of a pink block is sequentially relocated to a white block that has been designated as a relocation block (at steps 508 and 510). Once the relocation block is filled, it becomes a red block (at step 512). As noted above with reference to the write block, a relocation block may also make the direct transition to a pink block if some pages within it have already become obsolete. This transition is not shown, for clarity, but could be represented by an arrow from the relocation block to a pink block in FIG. 5.

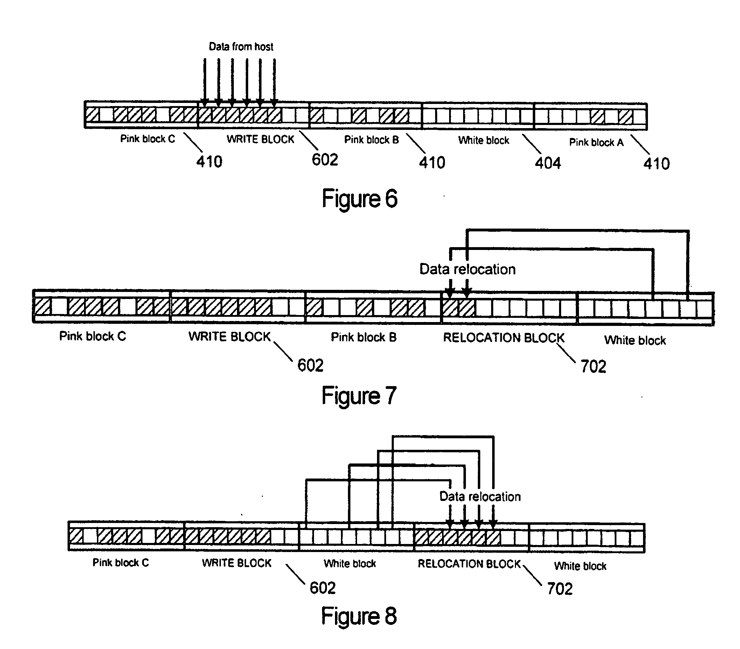

FIG. 6 illustrates an example pattern of valid data (shaded squares), obsolete data (unshaded squares in pink blocks A-C 410) and unwritten capacity (unshaded squares in write block 602 and white block 404) in the memory system. Each of the shaded or unshaded squares of the blocks of squares illustrated in FIGS. 6-8 represents a subunit of addresses in an erase block, or a metablock. These subunits of addresses, although shown as having equal size for purposes of simplifying this illustration, may be of the same size or different size.

In the physical blocks shown in FIG. 6, obsolete data 408 are dispersed at essentially random locations. When the host has data to write to the memory device, the write block 602 may be written to in sequential order such that contiguous locations in the write block 602 are filled. The locations in the write block 602 do not necessarily have to be filled in one operation. When a write block 602 becomes filled, a white block 404 may be allocated as the next write block 602.

An illustration of a flush operation of a physical block is shown in FIGS. 6-8. A white block 404 may be designated as a relocation block 702, to which data is to be flushed from selected pink blocks to create additional white blocks. Data is relocated from locations containing valid data in the flush block (in this example, shaded squares of pink block A of FIG. 6) to sequential clusters of available capacity in the relocation block 702 (shown as unshaded squares in white block 404), to convert the flush block to a white block 404. A next flush block (pink block B of FIG. 6) may be identified from the remaining pink blocks as illustrated in FIG. 8. The pink block 410 with the least amount of valid data is again designated as the flush block and the valid data of the selected pink block 410 is transferred to sequential locations in the open relocation block.

Flush operations on pink blocks may be performed as background operations to create white blocks at a rate sufficient to compensate for the consumption of white blocks that are designated as write blocks. Flush operations may also be performed as foreground operations to create additional white blocks as needed. The example of FIGS. 6-8 illustrates how a write block and a relocation block may be separately maintained for new data from the host and for relocated data from pink blocks. In other implementations, the new data and the relocated data may be transferred to a single write block without the need for separate write and relocation blocks. Also, in order to track the remapping of host LBA data, the storage address table (SAT) noted above is generated and stored in the memory system 102 that records the host LBA addresses mapped by the host to physical storage addresses.

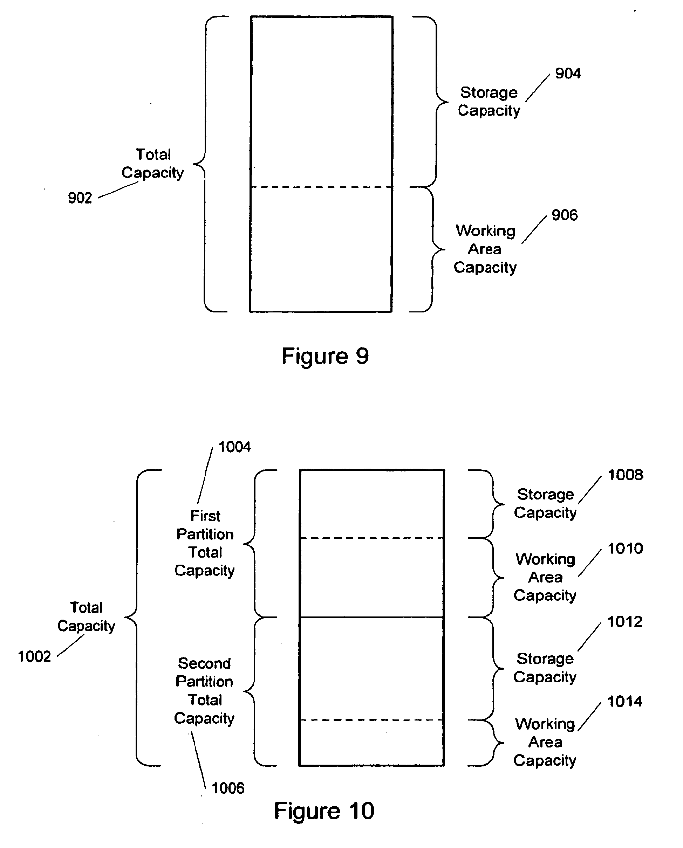

FIG. 9 illustrates an example memory capacity organization of the memory system 102. The memory system 102 has a total capacity 902 that includes a storage capacity 904 and a working area capacity 906. The storage capacity 904 may be used for data storage. A host system 100 writes data to and reads data from the data storage area of the memory system 102. The working area capacity 906 may be used as a garbage collection space and/or as a buffer for incoming data. As a garbage collection space, the working area capacity 906 is used as described above, where pink blocks are flushed of valid data to create white blocks as needed. The working area capacity 906 is less than or equal to the storage capacity 904 subtracted from the total capacity 902.

The division of the total capacity 902 between the storage capacity 904 and the working area capacity 906 is not necessarily fixed and permanent, and is a logical division, as opposed to a physical division. A given block may be included in the storage capacity 904 at one point in time and may be included in the working area capacity 906 at another point in time. For example, as described previously, a block may move from being a white block in the working area capacity 906 to a red block in the storage capacity 904.

The working area capacity 906 is equal or slightly less than the total capacity 902 minus the maximum amount of storage capacity 904 made available to a user of the memory system 102. For example, if the memory system 102 includes 4,096 blocks of 1 MB each (for a total physical capacity of 4,096 MB), and the storage capacity 904 available to a user is 4,000 MB, then the working area capacity 906 is 96 MB. The working area capacity 906 may be slightly less than 96 MB in this example if some of the blocks are used for other functions such as recording manufacturing or maintenance data.

The storage capacity 904 refers to the maximum allowable capacity available to the user and does not necessarily refer to the instantaneous available capacity at a specific point in time. The memory system 102 may take advantage of currently unused storage capacity to improve performance by using some of the unused storage capacity as working area capacity. For example, if a user has stored 3,000 MB in a device with a total physical capacity of 4,096 MB, the memory system 102 has 1,096 MB available at that time to use as a working area. However, the storage capacity 904 is 4,000 MB at all times and the working area capacity 906 is at most 96 MB at all times, regardless of possible instantaneous fluctuations in memory usage.

The amount of storage capacity 904 relative to the total capacity 902 may affect the write performance of the memory system 102. The write performance may include a burst write speed and/or a sustained write speed of the memory system 102. When the storage capacity 904 increases, less working area capacity 906 is available. More garbage collection operations may be necessary to ensure the availability of white blocks for incoming data to be written to. When looking for a block to garbage collect, the memory system 102 will generally attempt to find a block with a low number of valid pages, in order to reduce the amount of valid data that has to be moved. If the working area capacity 906 is relatively small, it is likely the blocks may have a larger number of valid pages and smaller number of obsolete pages, due to the random addressing of the stored data and because incoming data is written sequentially in a block regardless of the address of the data. Therefore, more write operations to move the valid pages will have to be performed.

Conversely, when the storage capacity 904 decreases, more working area capacity 906 is available and less garbage collection operations may be necessary. Blocks to be garbage collected may have a smaller number of valid pages and a larger number of obsolete pages. Correspondingly, fewer write operations to move the valid pages will have to be performed when there is more working area capacity 906 available.

As a non-limiting example, assume that the total capacity 902 of the memory system 102 is 100 GB, with the storage capacity 904 set to 99 GB and the working area capacity 906 set to I GB. When the storage capacity 904 is not full, assume the raw write performance of the memory system 102 is 100 MB/second. However, the write performance may change as the storage capacity 904 begins to fill up. If the storage capacity 904 is full and incoming data to be written is received, a block needs to be garbage collected in order to store the incoming data.

Because the working area capacity 906 is low, relative to the total capacity 902, the number of obsolete pages in a given block is also likely to be low, such as ten obsolete pages out of 128 pages in a block, for example. This number of obsolete pages is likely because when the storage capacity 904 is almost full, all of the blocks are in use, e.g., no white blocks are available. The pink blocks that exist would each probably contain few obsolete pages, particularly if the incoming input data is randomly addressed in the logical address space.

If a block with ten obsolete pages is garbage collected, the remaining 118 valid pages need to be relocated. Therefore, a total of 119 write operations are needed to store the incoming data, i.e., 118 write operations to move the valid pages to produce a white block and one write operation to store the incoming data in the white block. The effective write performance of the memory system 102 is equal to the raw write performance (100 MB/second) divided by the number of write operations needed to store the incoming data (119), or 0.84 MB/second in this example.

In contrast, if amount of the storage capacity 904 relative to the total capacity 902 is less, then the effective write performance of the memory system 102 may increase. Assume the total capacity 902 is again 100 GB, the storage capacity 904 is 50 GB, and the working area capacity 906 is 50 GB. As in the previous example, if the storage capacity 904 is full and incoming data to be written is received, a block needs to be garbage collected in order to store the incoming data. In this example, the working area capacity 906 is higher, relative to the total capacity 902, so the number of obsolete pages in a given block is likely to be higher than in the previous example. There could be 74 obsolete pages out of 128 pages in a block, for example. This number of obsolete pages is likely because when the storage capacity 904 in this example is full, then the total capacity is 50% full. In this case, each pink block is 50% full with 64 valid pages and 64 obsolete pages, on average. Following on from the previous example, the pink block most likely to be garbage collected could have 10 obsolete pages more than the average 64 obsolete pages, resulting in a possible 74 obsolete pages in the block.

If a block with 74 obsolete pages is garbage collected, the remaining 54 valid pages need to be relocated. Therefore, a total of 55 write operations are needed to store the incoming data, i.e., 54 write operations to move the valid pages to produce a white block and one write operation to store the incoming data in the white block. The effective write performance in this example is 1.82 MB/second, equal to the raw write performance (100 MB/second) divided by the 55 write operations needed to store the incoming data. The effective write performance of this example is an improvement over the previous example, due to the increase in the working area capacity 906.

The effective write performance due to the larger working area capacity 906 can be further increased if the memory system 102 performs garbage collection and other housekeeping operations during times the memory system 102 is idle. Background flushing of partially obsolete blocks, as described previously, could create a larger number of available white blocks to be written to with incoming data. In this way, garbage collection would not necessarily need to be performed as new data is coming in, but instead blocks would already be available for writing. In this case, the effective write performance would approach the raw write performance as long as white blocks are available that had been cleared by the background flushing performed during idle times. A larger working area capacity 906 also has the effect of increasing the length of a burst of data that can be supported with fast burst performance.

An input to the memory system 102 may set the storage capacity 904 and the corresponding write performance level. Alternatively, the input may set the working area capacity 906, the write performance level, and/or a ratio of the storage capacity 904 to the working area capacity 906. The input may be a software command or hardware setting. By allowing a storage capacity, working area capacity, a write performance level, and/or the ratio to be configured to different settings, a desired write performance level may be attained, with a corresponding tradeoff between write performance and storage capacity 904. Any number of different write performance levels may be available. A software command to set the storage capacity, working area capacity, the write performance level, and/or the ratio may include commands sent from the host 100 to the memory system 102. A hardware setting 116 may include a switch, jumper, or other suitable control.

After the input with the desired setting is received, a controller in the memory system 102 may configure the storage capacity 904 to the maximum amount of data that can be stored corresponding to the desired setting. The logical address space that the controller allows the host to use may be set to match the desired setting, and the controller prohibits the host from using a logical address outside of the valid logical address space.

The setting of a storage capacity, a working area capacity, write performance level, and/or the ratio, whether by software or hardware, may be performed when formatting the memory system 102 and/or after formatting, e.g., during normal operation of the memory system 102. If the setting occurs during normal operation, one embodiment includes only allowing the storage capacity 904 to increase from its current capacity. In this scenario, if an attempt is made to decrease the storage capacity 904 during normal operation, the attempt will be prohibited resulting in maintaining the previous storage capacity 904 and not setting the decreased storage capacity. The controller in the memory system 102 may ignore the attempt to decrease the storage capacity 904 in this case. In this way, data which has already been written to the storage capacity 904 portion of the memory system 102 would not be lost or corrupted.

In one embodiment, the memory system 102 stores the same number of bits per cell, regardless of the setting of a storage capacity, a working area capacity, write performance level, and/or a ratio. For example, the memory system 102 may include single-level cells (SLC) or multi-level cells (MLC) that can contain single or multiple bits of data per cell, respectively. However, configuring the memory system 102 to have a certain write performance level by varying the storage capacity 904 and the working area capacity 906 is not dependent on changing the number of bits stored in cells.

FIG. 10 illustrates an example memory capacity organization for multiple partitions of the memory system 102. Each of the partitions has a total capacity 1004 and 1006 and each total capacity 1004 and 1006 has respective storage capacities 1008 and 1012 and working area capacities 1010 and 1014. A host system 100 may write data to and read data from one or both of the data storage areas with storage capacities 1008 and 1012. The working area capacities 1010 and 1014 may be used as a garbage collection space and/or as a buffer for incoming data to be written. Any number of partitions with respective total capacities, storage capacities, and working area capacities may be included in the memory system 102.

The storage capacities 1008 and 1012 relative to the total capacities 1004 and 1006 may be set for each of the partitions. The settings may be configured by an input to the memory system 102, such as a software command or hardware setting, as described previously. The storage capacities 1008 and 1012 for each of the partitions may be the same or different, the working area capacities 1010 and 1014 for each of the partitions may be the same or different, and the corresponding write performance levels for the partitions may vary depending on the storage capacities 1008 and 1012 and the working area capacities 1010 and 1014. As in the embodiment with one partition, for each of the partitions, if the storage capacities 1008 and 1002 increase, less working area capacity 1010 and 1014 is available, respectively. More garbage collection operations may be necessary to ensure the availability of white blocks for data to be written to. Conversely, when the storage capacities 1008 and 1012 decrease, more working area capacity 1010 and 1014 is available, respectively, and less garbage collection operations may be necessary. Less write operations to move the valid pages would have to be performed when there is more working area capacity 1010 and 1014 available.

Because each of the partitions may have a different storage capacity, the partitions may have different write performance levels. As such, incoming data may be written to one or to the other partition, depending on the write performance that is desired. For example, if incoming data includes highly randomly addressed data, the incoming data may be written to the partition with a smaller storage capacity and a higher write performance level, due to its increased working area capacity. Because each of the partitions does not need to have the same total capacity, a relatively small partition with high performance and a relatively large partition with lower performance may be created. In this way, a memory system may have the ability to receive input data with highly random addresses while not needing an increased working area capacity over the entire storage capacity.

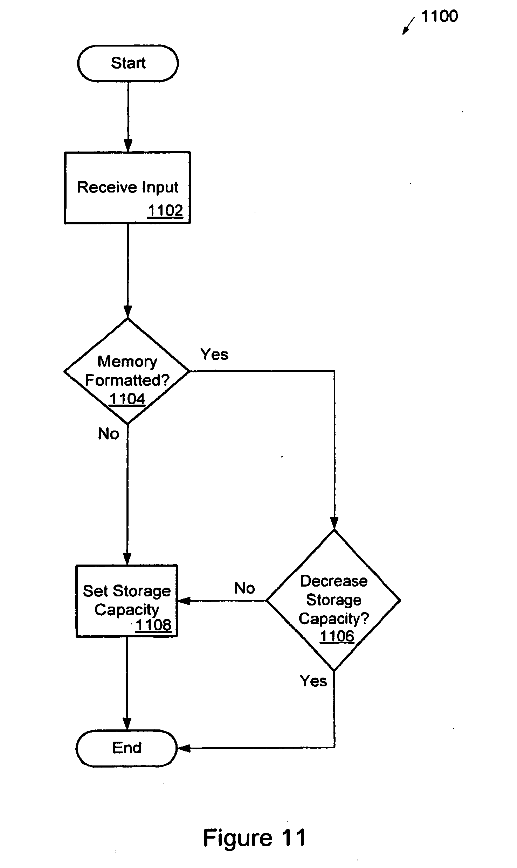

FIG. 11 is a flow diagram illustrating a method 1100 of setting a write performance mode of a memory device according to an embodiment. The write performance mode may correspond to a storage capacity of the memory device. A working area capacity makes up the remainder of the total capacity of the memory device. The storage capacity may be used to store data and the working area capacity may be used for garbage collection and other housekeeping operations. The write performance mode may correspond to a burst write speed or a sustained write speed of the memory device. As the storage capacity increases, the write performance of the memory device decreases, and vice versa.

At step 1102, the memory receives an input that sets the desired storage capacity, working area capacity, write performance level, and/or ratio of the storage capacity to the working area capacity for the memory device. The input may be received as a software command from an application running on a host, or as a hardware setting such as a jumper or switch setting, for example. At step 1104, it is determined whether the memory device has been formatted. Whether the memory device has been formatted determines if the storage capacity may be increased and/or decreased. If the memory has been formatted, the method 1100 continues to step 1106.

At step 1106, it is determined whether the input received at step 1102 is attempting to decrease the storage capacity of the memory device. If the input is attempting to decrease the storage capacity, then the method 1100 is complete. Because data may already be stored in the data storage area specified by the storage capacity, the storage capacity should not be decreased after the memory device has been formatted in order to protect against data loss and corruption. However, if the input received at step 1102 is attempting to increase or maintain the storage capacity at step 1106, then at step 1108, the desired storage capacity is set, and the method 1100 is complete. If the memory has not been formatted at step 1104, then the desired storage capacity is set at step 1108 and the method 1100 is complete. If the memory includes multiple partitions that each have a storage capacity, working area capacity, or write performance setting, then the method 1100 may be executed for each of the partitions.

A system and method has been disclosed for setting a write performance mode of a memory device. The write performance mode is set by varying the storage capacity of the memory device relative to total capacity of the memory device. A desired write performance mode may be set by receiving a software command or hardware setting. The storage capacity may be varied depending on whether the memory device has been formatted. As the storage capacity decreases, working area capacity of the memory device increases and write performance increases. Conversely, as the storage capacity increases, working area capacity decreases and write performance decreases.

## Claims

1. A method for controlling a memory (112), comprising:
receiving (1102) an input at the memory (102);
if the input comprises a first input, configuring the memory (112) to a first operation mode, the first operation mode providing a first write performance level and a first storage capacity (904; 1008; 1012); and
if the input comprises a second input, configuring the memory (112) to a second operation mode, the second operation mode providing a second write performance level and a second storage capacity (904; 1008; 1012);
wherein:
the first operation mode and the second operation mode store a same number of bits per cell in the memory (112); and
the first storage capacity (904; 1008; 1012) is larger than the second storage capacity (904; 1008; 1012);
**CHARACTERISED IN THAT**:
a ratio of first working area capacity (906; 1010; 1014) reserved for internal use within the memory to first storage capacity (904; 1008; 1012) in the first operation mode is less than a ratio of second working area capacity (906; 1010; 1014) reserved for internal use within the memory to second storage capacity (904; 1008; 1012) in the second write performance mode such that the first write performance level is lower than the second write performance level, wherein the first and second write performance levels are first and second write speeds respectively and wherein the first and second working area capacities (906; 1010; 1014) comprise at least one of a buffer or a garbage collection space.

2. The method of claim 1, further comprising prohibiting configuration of the memory (112) to the second operation mode if the memory has already been formatted.

3. The method of claim 1, wherein the first and second write performance levels comprise at least one of a burst write speed or a sustained write speed.

4. The method of claim 1, wherein:
configuring the memory (112) to the first operation mode comprises allocating a first working area capacity (906; 1010, 1014) for internal use within the memory (112), the first working area capacity (906; 1010, 1014) less than or equal to the first storage capacity (904; 1008; 1012) subtracted from a total capacity (902; 1004, 1006); and
configuring the memory (112) to the second operation mode comprises allocating a second working area capacity (906; 1010, 1014) for internal use within the memory (112), the second working area capacity (906; 1010, 1014) less than or equal to the second storage capacity (904; 1008; 1012) subtracted from the total capacity (902; 1004, 1006).

5. The method of claim 1, wherein the input comprises a software command specifying at least one of a write performance level or a storage capacity.

6. The method of claim 1, wherein the input comprises a hardware setting specifying at least one of a write performance level or a storage capacity.

7. The method of claim 1, wherein the input affects only a portion of a storage capacity of the memory (112).

8. A memory device (102), comprising:
a memory (112); and
a controller (114) for controlling the memory (112) and configured to:
receive an input at the memory (112);
if the input comprises a first input, configure the memory (112) to a first operation mode, the first operation mode providing a first write performance level and a first storage capacity (904; 1008; 1012); and
if the input comprises a second input, configure the memory (112) to a second operation mode, the second operation mode providing a second write performance level and a second storage capacity (904; 1008; 1012);
wherein:
the first storage capacity (904; 1008; 1012) is larger than the second storage capacity (904; 1008; 1012); and
the first operation mode and the second operation mode store a same number of bits per cell in the memory (112)
**CHARACTERISED IN THAT**:
a ratio of first working area capacity (906; 1010; 1014) reserved for internal use within the memory to first storage capacity (904; 1008; 1012) in the first operation mode is less than a ratio of second working area capacity (906; 1010; 1014) reserved for internal use within the memory to second storage capacity (904; 1008; 1012) in the second operating mode such that the first write performance level is lower than the second write performance level, wherein the first and second write performance levels are first and second write speeds respectively and wherein the first and second working area capacities (906; 1010; 1014) comprise at least one of a buffer or a garbage collection space.

9. The memory device of claim 8, wherein the controller (114) is further configured to prohibit configuration of the memory (112) to the second operation mode if the memory (112) has already been formatted.

10. The memory device of claim 8, wherein the first and second write performance levels comprise at least one of a burst write speed or a sustained write speed.

11. The memory device of claim 8, wherein:
the controller (114) is further configured to, in the first operation mode, allocate a first working area capacity (906; 1010,1014) for internal use within the memory (112), the first working area capacity (906; 1010, 1014) less than or equal to the first storage capacity (906; 1010, 1014) subtracted from a total capacity (902; 1004, 1006); and
the controller (14) is further configured to, in the second operation mode, allocate a second working area capacity (906; 1010, 1014) for internal use within the memory (112), the second working area capacity (906; 1010, 1014) less than or equal to the second storage capacity (904; 1008; 1012) subtracted from the total capacity (902; 1004, 1006).

12. The memory device of claim 8, wherein the input comprises a software command specifying at least one of a write performance level or a storage capacity (904; 1008; 1012).

13. The memory device of claim 8, wherein the memory device (102) comprises a hardware interface for receiving the input, the input specifying at least one of a write performance level or a storage capacity (904; 1008; 1012).

## Patentansprüche

1. Verfahren zum Steuern eines Speichers (112), Folgendes umfassend:
Empfangen (1102) einer Eingabe am Speicher (102);
falls die Eingabe eine erste Eingabe umfasst, Konfigurieren des Speichers (112) für einen ersten Operationsmodus, wobei der erste Operationsmodus eine erste Schreibleistungsstufe und eine erste Speicherkapazität (904; 1008; 1012) bereitstellt; und
falls die Eingabe eine zweite Eingabe umfasst, Konfigurieren des Speichers (112) für einen zweiten Operationsmodus, wobei der zweite Operationsmodus eine zweite Schreibleistungsstufe und eine zweite Speicherkapazität (904; 1008; 1012) bereitstellt;
worin:
der erste Operationsmodus und der zweite Operationsmodus eine identische Anzahl von Bits pro Zelle im Speicher (112) speichern; und
die erste Speicherkapazität (904; 1008; 1012) größer ist als die zweite Speicherkapazität (904; 1008; 1012);
**dadurch gekennzeichnet, dass**:
ein Verhältnis der ersten Arbeitsbereichkapazität (906; 1010; 1014), die für interne Verwendung innerhalb des Speichers reserviert ist, zur ersten Speicherkapazität (904; 1008; 1012) im ersten Operationsmodus kleiner ist als ein Verhältnis der zweiten Arbeitsbereichkapazität (906; 1010; 1014), die für interne Verwendung innerhalb des Speichers reserviert ist, zur zweiten Speicherkapazität (904; 1008; 1012) im zweiten Schreibleistungsmodus, sodass die erste Schreibleistungsstufe niedriger ist als die zweite Schreibleistungsstufe, worin die ersten und zweiten Schreibleistungsstufen erste bzw. zweite Schreibgeschwindigkeiten sind und worin die ersten und zweiten Arbeitsbereichkapazitäten (906; 1010; 1014) mindestens einen eines Puffers oder eines Speicherbereinigungsplatzes umfassen.

2. Verfahren nach Anspruch 1, außerdem umfassend, dass die Konfiguration des Speichers (112) für den zweiten Operationsmodus verhindert wird, falls der Speicher schon formatiert wurde.

3. Verfahren nach Anspruch 1, worin die ersten und zweiten Schreibleistungsstufen mindestens eine einer Burst-Schreibgeschwindigkeit oder einer Dauer-Schreibgeschwindigkeit umfassen.

4. Verfahren nach Anspruch 1, worin:
das Konfigurieren des Speichers (112) für den ersten Operationsmodus das Zuweisen einer ersten Arbeitsbereichkapazität (906; 1010; 1014) zur internen Verwendung innerhalb des Speichers (112) umfasst, wobei die erste Arbeitsbereichkapazität (906; 1010; 1014) kleiner oder gleich der von einer Gesamtkapazität (902; 1004; 1006) subtrahierten ersten Speicherkapazität (904; 1008; 1012) ist; und
das Konfigurieren des Speichers (112) für den zweiten Operationsmodus das Zuweisen einer zweiten Arbeitsbereichkapazität (906; 1010; 1014) zur internen Verwendung innerhalb des Speichers (112) umfasst, wobei die zweite Arbeitsbereichkapazität (906; 1010; 1014) kleiner oder gleich der von der Gesamtkapazität (902; 1004; 1006) subtrahierten zweiten Speicherkapazität (904; 1008; 1012) ist.

5. Verfahren nach Anspruch 1, worin die Eingabe einen Softwarebefehl umfasst, der mindestens eine einer Schreibleistungsstufe oder einer Speicherkapazität spezifiziert.

6. Verfahren nach Anspruch 1, worin die Eingabe eine Hardwareeinstellung umfasst, die mindestens eine einer Schreibleistungsstufe oder einer Speicherkapazität spezifiziert.

7. Verfahren nach Anspruch 1, worin die Eingabe nur einen Teil einer Speicherkapazität des Speichers (112) beeinflusst.

8. Speichereinrichtung (102), Folgendes umfassend:
einen Speicher (112); und
einen Controller (114) zum Steuern des Speichers (112) und konfiguriert zum:
Empfangen einer Eingabe am Speicher (112);
falls die Eingabe eine erste Eingabe umfasst, Konfigurieren des Speichers (112) für einen ersten Operationsmodus, wobei der erste Operationsmodus eine erste Schreibleistungsstufe und eine erste Speicherkapazität (904; 1008; 1012) bereitstellt; und
falls die Eingabe eine zweite Eingabe umfasst, Konfigurieren des Speichers (112) für einen zweiten Operationsmodus, wobei der zweite Operationsmodus eine zweite Schreibleistungsstufe und eine zweite Speicherkapazität (904; 1008; 1012) bereitstellt;
worin:
die erste Speicherkapazität (904; 1008; 1012) größer ist als die zweite Speicherkapazität (904; 1008; 1012); und
der erste Operationsmodus und der zweite Operationsmodus eine identische Anzahl von Bits pro Zelle im Speicher (112) speichern;
**dadurch gekennzeichnet, dass**:
ein Verhältnis der ersten Arbeitsbereichkapazität (906; 1010; 1014), die für interne Verwendung innerhalb des Speichers reserviert ist, zur ersten Speicherkapazität (904; 1008; 1012) im ersten Operationsmodus kleiner ist als ein Verhältnis der zweiten Arbeitsbereichkapazität (906; 1010; 1014), die für interne Verwendung innerhalb des Speichers reserviert ist, zur zweiten Speicherkapazität (904; 1008; 1012) im zweiten Operationsmodus, sodass die erste Schreibleistungsstufe niedriger ist als die zweite Schreibleistungsstufe, worin die ersten und zweiten Schreibleistungsstufen erste bzw. zweite Schreibgeschwindigkeiten sind und worin die ersten und zweiten Arbeitsbereichkapazitäten (906; 1010; 1014) mindestens einen eines Puffers oder eines Speicherbereinigungsplatzes umfassen.

9. Speichereinrichtung nach Anspruch 8, worin der Controller (114) außerdem dazu konfiguriert ist, die Konfiguration des Speichers (112) für den zweiten Operationsmodus zu verhindern, falls der Speicher (112) schon formatiert wurde.

10. Speichereinrichtung nach Anspruch 8, worin die ersten und zweiten Schreibleistungsstufen mindestens eine einer Burst-Schreibgeschwindigkeit oder einer Dauer-Schreibgeschwindigkeit umfassen.

11. Speichereinrichtung nach Anspruch 8, worin:
der Controller (114) außerdem dazu konfiguriert ist, im ersten Operationsmodus eine erste Arbeitsbereichkapazität (906; 1010; 1014) zur internen Verwendung innerhalb des Speichers (112) zuzuweisen, wobei die erste Arbeitsbereichkapazität (906; 1010; 1014) kleiner oder gleich der von einer Gesamtkapazität (902; 1004; 1006) subtrahierten ersten Speicherkapazität (906; 1010; 1014) ist; und
der Controller (114) außerdem dazu konfiguriert ist, im zweiten Operationsmodus eine zweite Arbeitsbereichkapazität (906; 1010; 1014) zur internen Verwendung innerhalb des Speichers (112) zuzuweisen, wobei die zweite Arbeitsbereichkapazität (906; 1010; 1014) kleiner oder gleich der von der Gesamtkapazität (902; 1004; 1006) subtrahierten zweiten Speicherkapazität (904; 1008; 1012) ist.

12. Speichereinrichtung nach Anspruch 8, worin die Eingabe einen Softwarebefehl umfasst, der mindestens eine einer Schreibleistungsstufe oder einer Speicherkapazität (904; 1008; 1012) spezifiziert.

13. Speichereinrichtung nach Anspruch 8, worin die Speichereinrichtung (102) eine Hardwareschnittstelle zum Empfangen der Eingabe umfasst, wobei die Eingabe mindestens eine einer Schreibleistungsstufe oder einer Speicherkapazität (904; 1008; 1012) spezifiziert.

## Revendications

1. Procédé de commande d'une mémoire (112), consistant à :
recevoir (1102) une entrée au niveau de la mémoire (102) ;
si l'entrée comprend une première entrée, configurer la mémoire (112) sur un premier mode de fonctionnement, le premier mode de fonctionnement fournissant un premier niveau de performance d'écriture et une première capacité de stockage (904 ; 1008 ; 1012) ; et
si l'entrée comprend une seconde entrée, configurer la mémoire (112) sur un second mode de fonctionnement, le second mode de fonctionnement fournissant un second niveau de performance d'écriture et une seconde capacité de stockage (904 ; 1008 ; 1012) ;
dans lequel :
le premier mode de fonctionnement et le second mode de fonctionnement stockent un même nombre de bits par cellule dans la mémoire (112) ; et
la première capacité de stockage (904 ; 1008 ; 1012) est supérieure à la seconde capacité de stockage (904 ; 1008 ; 1012) ;
**caractérisé en ce que** :
un rapport entre une première capacité de zone de travail (906 ; 1010; 1014) réservée à un usage interne au sein de la mémoire et la première capacité de stockage (904 ; 1008 ; 1012) dans le premier mode de fonctionnement est inférieur à un rapport entre une seconde capacité de zone de travail (906 ; 1010; 1014) réservée à un usage interne au sein de la mémoire et la seconde capacité de stockage (904 ; 1008 ; 1012) dans le second mode de performance d'écriture, de sorte que le premier niveau de performance d'écriture est inférieur au second niveau de performance d'écriture, dans lequel les premier et second niveaux de performance d'écriture correspondent à des première et seconde vitesses d'écriture, respectivement, et dans lequel les première et seconde capacités de zone de travail (906 ; 1010 ; 1014) comprennent au moins l'un des éléments parmi une mémoire tampon ou un espace de récupération de place.

2. Procédé selon la revendication 1, consistant en outre à interdire une configuration de la mémoire (112) sur le second mode de fonctionnement, si la mémoire a déjà été formatée.

3. Procédé selon la revendication 1, dans lequel les premier et second niveaux de performance d'écriture comprennent au moins l'une parmi une vitesse d'écriture par salves ou une vitesse d'écriture constante.

4. Procédé selon la revendication 1, dans lequel :
la configuration de la mémoire (112) sur le premier mode de fonctionnement consiste à affecter une première capacité de zone de travail (906 ; 1010, 1014) pour un usage interne au sein de la mémoire (112), la première capacité de zone de travail (906 ; 1010, 1014) étant inférieure ou égale à la première capacité de stockage (904 ; 1008 ; 1012) soustraite d'une capacité totale (902 ; 1004, 1006) ; et
la configuration de la mémoire (112) sur le second mode de fonctionnement consiste à affecter une seconde capacité de zone de travail (906 ; 1010, 1014) pour un usage interne au sein de la mémoire (112), la seconde capacité de zone de travail (906 ; 1010, 1014) étant inférieure ou égale à la seconde capacité de stockage (904 ; 1008 ; 1012) soustraite de la capacité totale (902 ; 1004, 1006).

5. Procédé selon la revendication 1, dans lequel l'entrée comprend une commande logicielle spécifiant au moins l'une des caractéristiques parmi un niveau de performance d'écriture ou une capacité de stockage.

6. Procédé selon la revendication 1, dans lequel l'entrée comprend un paramètre matériel spécifiant au moins l'une des caractéristiques parmi un niveau de performance d'écriture ou une capacité de stockage.

7. Procédé selon la revendication 1, dans lequel l'entrée affecte uniquement une partie d'une capacité de stockage de la mémoire (112).

8. Dispositif de mémoire (102), comprenant :
une mémoire (112) ; et
un contrôleur (114) destiné à commander la mémoire (112) et configuré de manière à :
recevoir une entrée au niveau de la mémoire (112) ;
si l'entrée comprend une première entrée, configurer la mémoire (112) sur un premier mode de fonctionnement, le premier mode de fonctionnement fournissant un premier niveau de performance d'écriture et une première capacité de stockage (904 ; 1008 ; 1012) ; et
si l'entrée comprend une seconde entrée, configurer la mémoire (112) sur un second mode de fonctionnement, le second mode de fonctionnement fournissant un second niveau de performance d'écriture et une seconde capacité de stockage (904 ; 1008 ; 1012) ;
dans lequel :
la première capacité de stockage (904 ; 1008 ; 1012) est supérieure à la seconde capacité de stockage (904 ; 1008 ; 1012) ; et
le premier mode de fonctionnement et le second mode de fonctionnement stockent un même nombre de bits par cellule dans la mémoire (112) ;
**caractérisé en ce que** :
un rapport entre une première capacité de zone de travail (906 ; 1010; 1014) réservée à un usage interne au sein de la mémoire et la première capacité de stockage (904 ; 1008 ; 1012) dans le premier mode de fonctionnement est inférieur à un rapport entre une seconde capacité de zone de travail (906 ; 1010; 1014) réservée à un usage interne au sein de la mémoire et la seconde capacité de stockage (904 ; 1008 ; 1012) dans le second mode de performance d'écriture, de sorte que le premier niveau de performance d'écriture est inférieur au second niveau de performance d'écriture, dans lequel les premier et second niveaux de performance d'écriture correspondent à des première et seconde vitesses d'écriture, respectivement, et dans lequel les première et seconde capacités de zone de travail (906 ; 1010 ; 1014) comprennent au moins l'un des éléments parmi une mémoire tampon ou un espace de récupération de place.

9. Dispositif de mémoire selon la revendication 8, dans lequel le contrôleur (114) est en outre configuré de manière à interdire une configuration de la mémoire (112) sur le second mode de fonctionnement, si la mémoire (112) a déjà été formatée.

10. Dispositif de mémoire selon la revendication 8, dans lequel les premier et second niveaux de performance d'écriture comprennent au moins l'une parmi une vitesse d'écriture par salves et une vitesse d'écriture constante.

11. Dispositif de mémoire selon la revendication 8, dans lequel :
le contrôleur (114) est en outre configuré de manière à, dans le premier mode de fonctionnement, affecter une première capacité de zone de travail (906 ; 1010, 1014) pour un usage interne au sein de la mémoire (112), la première capacité de zone de travail (906 ; 1010, 1014) étant inférieure ou égale à la première capacité de stockage (906 ; 1010, 1014) soustraite d'une capacité totale (902 ; 1004, 1006) ; et
le contrôleur (114) est en outre configuré de manière à, dans le second mode de fonctionnement, affecter une seconde capacité de zone de travail (906 ; 1010, 1014) pour un usage interne au sein de la mémoire (112), la seconde capacité de zone de travail (906 ; 1010, 1014) étant inférieure ou égale à la seconde capacité de stockage (904 ; 1008 ; 1012) soustraite de la capacité totale (902 ; 1004, 1006).

12. Dispositif de mémoire selon la revendication 8, dans lequel l'entrée comprend une commande logicielle spécifiant au moins l'une des caractéristiques parmi un niveau de performance d'écriture ou une capacité de stockage (904 ; 1008 ; 1012).

13. Dispositif de mémoire selon la revendication 8, dans lequel le dispositif de mémoire (102) comprend une interface matérielle destinée à recevoir l'entrée, l'entrée spécifiant au moins l'une des caractéristiques parmi un niveau de performance d'écriture ou une capacité de stockage (904 ; 1008 ; 1012).
